# FASCICULE DE BREVET EUROPEEN

(11) **EP 2 898 543 B1**
(45) Date de publication et mention de la délivrance du brevet: **28.11.2018**
(21) Numéro de dépôt: 13780180.9
(22) Date de dépôt: 23.09.2013
(51) Int. Cl.: H01L 31/18

(54) **PROCÉDÉ DE RÉALISATION D'UNE CELLULE PHOTOVOLTAÏQUE À HÉTÉROJONCTION**
VERFAHREN ZUR HERSTELLUNG EINER PV-ZELLE MIT HETEROÜBERGANG
METHOD FOR PRODUCING A PHOTOVOLTAIC CELL HAVING A HETEROJUNCTION

(30) Priorité: 24.09.2012 FR 1202533
(43) Date de publication de la demande: 29.07.2015
(73) Titulaire: Commissariat à l'Energie Atomique et aux Energies Alternatives, 75015 Paris (FR)
(72) Inventeur: OZANNE, Anne-Sophie, F-38580 Allevard (FR); MUNOZ, Maria-Delfina, F-38380 Saint Christophe sur Guiers (FR); NGUYEN, Nathalie, F-73800 Les Marches (FR)
(74) Mandataire: Talbot, Alexandre
(86) Numéro de dépôt international: PCT/FR2013/000250
(87) Numéro de publication internationale: WO 2014/044933

(56) Documents cités:
- EP-A2- 1 187 223
- EP-A2- 1 643 564
- DE-A1-102010 030 696
- FR-A1- 2 955 702
- US-A1- 2011 297 227
- US-A1- 2012 015 474

## Description

### Domaine technique de l'invention

L'invention est relative à un procédé de réalisation d'une cellule photovoltaïque à hétérojonction.

### État de la technique

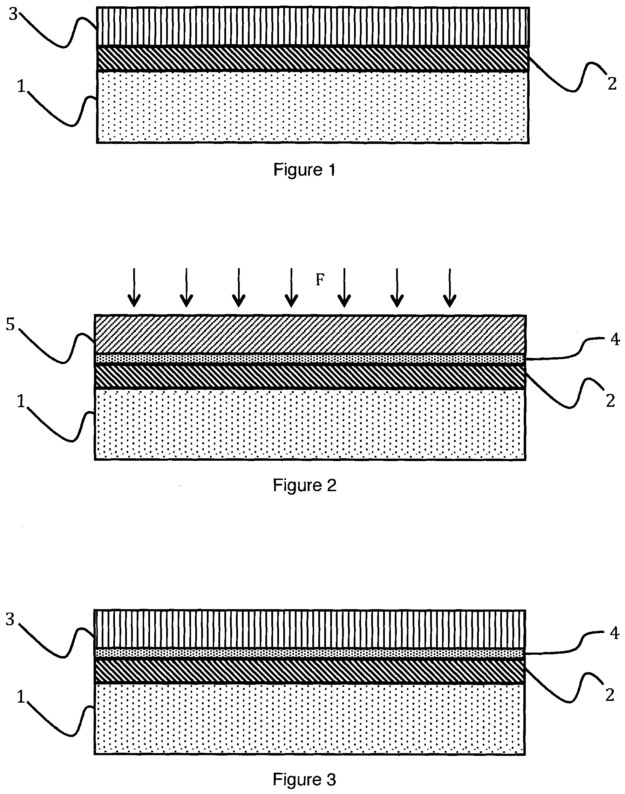

Une cellule photovoltaïque peut être formée par un empilement multicouche, comprenant le plus souvent des matériaux semi-conducteurs, tels que le silicium, et permettant de convertir directement les photons reçus en un signal électrique. Comme représenté sur la figure 1, classiquement, une cellule photovoltaïque à hétérojonction comprend successivement :
- un substrat 1, en silicium cristallin, dopé selon un type prédéterminé n ou p (aussi noté (n) c-Si ou (p) c-Si selon la nature du dopage),
- une première couche 2 en silicium amorphe non intentionnellement dopé, également appelé silicium amorphe intrinsèque et susceptible d'être noté (i) a-Si ou (i) a-Si : H), pour passiver la surface du substrat, ladite couche étant appelée couche de passivation 2,
- une deuxième couche 3 en silicium amorphe dopé selon un type de dopage p ou n opposé à celui du substrat 1, et susceptible d'être noté (p) a-Si (ou encore (p) a-Si : H) ou (n) a-Si (ou encore (n) a-Si :H), selon la nature du dopage),
- éventuellement une couche anti-reflet (non représentée sur la figure 1),
- et des contacts électriques (non représentés sur la figure 1).

Pour former la deuxième couche 3, deux techniques sont couramment utilisées. La première technique consiste à déposer une couche en silicium amorphe par dépôt en phase vapeur assisté par plasma (PECVD), et à réaliser le dopage par introduction d'un gaz dopant lors du dépôt PECVD. La deuxième technique consiste à réaliser une implantation ionique pour doper une couche en silicium amorphe intrinsèque préalablement déposée sur le substrat 1.

Le dopage des matériaux semi-conducteurs par implantation ionique est un procédé connu depuis de nombreuses années. Le document « Electrical Behavior of Group III and V Implanted Dopants in SIlicon » de Baron et al. (Journal of Applied Physics (1969), 40, 3702) décrit par exemple le comportement de substrats en silicium dopés par différents éléments III et V par implantation ionique.

Ce procédé d'implantation ionique peut être appliqué pour réaliser des dispositifs semi-conducteurs comportant des transistors à jonction, comme décrit dans le brevet US 7,787,564. Un substrat en germanium dopé N est bombardé par un faisceau d'ions contenant du bore pour former dans le substrat une zone dopée P. Le substrat est ensuite recuit à des températures de l'ordre de 400°C pour réparer les dommages causés par le faisceau.

La demande de brevet WO-A-2011/078521 décrit, par exemple, une cellule photovoltaïque à hétérojonction en silicium de type BSF (ou à champ de surface arrière) et son procédé d'élaboration mettant en oeuvre des dopages par implantation ionique.

De même, les articles « A study of the Factors which Control the Efficiency of ion-Implanted Silicon Solar Cells » de Douglas et al. (IEEE Transactions on Electron Devices (1980), 27, 4, 792-802) et « Tailored Emitter, Low-Resistivity, Ion-Implanted Silicon Solar Cells » de Minnucci et al. (IEEE Transactions on Electron Devices (1980), 27, 4, 802-806) décrivent différentes cellules photovoltaïques en silicium dont le procédé d'élaboration comprend une étape de dopage par implantation ionique. Après implantation ionique, les substrats sont recuits à des températures supérieures à 500°C. Ces documents montrent que de nombreux paramètres, utilisés lors de l'élaboration des cellules photovoltaïques, ont une influence sur les performances des cellules. Il s'agit par exemple de l'énergie d'implantation, de la nature de l'espèce utilisée lors de l'implantation, de la concentration en dopant, de l'orientation du substrat, de la résistivité du substrat...

Les documents « Electrical Behavior of Group III and V Implanted Dopants in SIlicon » de Baron et al. (Journal of Applied Physics (1969), 40, 3702) et « Ion Implantation in Semiconductors - Part I Range Distribution Theory and Experiments » de Gibbons (Proceedings of the IEEE (1968), 56, 3, 295-319) confirment que les processus d'implantation ionique sont très complexes et que les profils d'implantation sont très difficiles à prévoir puisqu'ils dépendent fortement des conditions expérimentales : température, nature des ions à implanter, orientation du faisceau, structure cristalline du matériau à doper...

De plus, comme les couches à doper présentent généralement de faibles épaisseurs, il est particulièrement difficile de contrôler précisément le profil de l'implantation ionique.

Il est donc généralement nécessaire pour obtenir le profil d'implantation souhaité, dans un matériau semi-conducteur, de tester expérimentalement les paramètres d'implantation, ce qui nécessite de nombreux essais, fastidieux et coûteux.

Le document US2012/0015474 propose une méthode de fabrication de cellules solaires à hétérojonction dans laquelle des couches barrières sont disposées au dessus des couches amorphes à doper, pour un meilleur contrôle de l'étape d'implantation.

### Objet de l'invention

L'invention a pour but de remédier aux inconvénients de l'art antérieur et, en particulier, de proposer un procédé de réalisation d'une cellule photovoltaïque à hétérojonction, simple, facile à mettre en oeuvre, robuste et reproductible. Plus particulièrement, elle a pour objet de permettre la réalisation d'un dopage par implantation ionique d'au moins une des couches minces de la cellule photovoltaïque de manière contrôlée et efficace, afin d'augmenter les performances de la cellule photovoltaïque.

L'objet de l'invention est défini par la revendication 1. Les modes de réalisation préférés sont définis dans les revendications 2 à 9.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente, de manière schématique et en coupe, une cellule photovoltaïque selon l'art antérieur,
- les figures 2 et 3 représentent, respectivement, de manière schématique et en coupe, une étape du procédé de réalisation selon un premier mode de réalisation et la cellule photovoltaïque ainsi obtenue,
- les figures 4 et 5 représentent, respectivement, de manière schématique et en coupe, une étape du procédé de réalisation selon un premier mode de réalisation et la cellule photovoltaïque ainsi obtenue,
- les figures 6 et 7 représentent, respectivement, de manière schématique et en coupe, une étape du procédé de réalisation selon un premier mode de réalisation et la cellule photovoltaïque ainsi obtenue.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

### Description d'un mode de réalisation préférentiel de l'invention

Comme représenté sur les figures 2 et 3, une cellule photovoltaïque à hétérojonction est obtenue en formant la deuxième couche 3 par dopage par implantation ionique (les flèches F représentent schématiquement la direction d'implantation ionique) d'une couche 5 en silicium amorphe préalablement déposée et initialement non dopée (i.e en silicium amorphe intrinsèque) ou pas assez dopée.

Il est rappelé que le dopage par implantation ionique consiste à introduire des agents dopants électriquement actifs, en particulier sous la forme d'ions, dans un matériau semi-conducteur et notamment dans du silicium, de sorte à modifier localement la conductivité électrique du matériau semi-conducteur. Les agents dopants utilisés pour le dopage sont par exemple le bore ou le phosphore. Il peut s'agir aussi d'aluminium ou de gallium. Les agents dopants implantés et/ou la teneur en agents dopants sont classiquement choisis en fonction du type de dopage que l'on souhaite apporter au matériau semi-conducteur. La réalisation d'un dopage par implantation ionique permet, avantageusement, de maîtriser la quantité d'agents dopants implantés et de doper sélectivement (localement) le matériau semi-conducteur. Il est, ainsi, possible de définir des motifs localisés avec différents niveaux de dopage.

Par ailleurs, comme illustré sur les figures 2 et 3, une couche barrière 4 est formée sur la première couche 2 avant la formation de la couche 5. En effet, le fait de disposer une couche barrière 4 entre les couches 2 et 5 permet d'empêcher, lors de l'étape de dopage par implantation ionique, la pénétration des ions, dans la première couche 2 et dans le substrat cristallin 1. Ces couches ne sont alors pas contaminées lors du dopage par implantation ionique et les performances de la cellule sont améliorées.

Ainsi, dans un mode avantageux, le substrat 1 est préférentiellement en silicium cristallin, par exemple dopé N. Il comprend deux faces principales : la face avant et la face arrière. La face avant est constituée en général par la face du substrat, sur laquelle est disposé un empilement de couches minces destiné à être directement exposé au rayonnement incident tandis que la face arrière est la face opposée du substrat.

La première couche 2, déposée sur la face avant du substrat 1, est une couche en silicium amorphe intrinsèque aussi appelée couche de passivation, Elle permet de passiver la surface du substrat, c'est-à-dire de limiter la recombinaison des porteurs de charge à la surface du substrat 1. Les propriétés de la couche de passivation sont configurées de manière à conserver la jonction photovoltaïque entre le substrat 1 et la première couche 2.

Dans le mode de réalisation représenté sur les figures 2 et 3, la deuxième couche 3 est obtenue par dopage par implantation ionique de la couche 5, selon un type de dopage opposé à celui du substrat pour réaliser une jonction p/n. Dans le cas d'un substrat de type N, la couche 3 est ainsi dopée selon le type P. Les couches 2, 3 et aussi par conséquent la couche 5 ont préférentiellement une épaisseur inférieure à 15nm chacune et avantageusement supérieure ou égale à 1nm.

La présence de la couche barrière 4 permet avantageusement de réduire l'épaisseur de la couche amorphe dopée 3, puisque même si l'épaisseur de la couche en silicium amorphe non dopé 5 est très fine, l'implantation ionique sera bloquée par la couche barrière 4 et les dopants n'atteindront pas la couche en silicium amorphe intrinsèque 2. L'épaisseur de la couche en silicium amorphe dopé 3 est, selon un mode de réalisation préférentiel, inférieure à 12 nm. Une couche de faible épaisseur permet, avantageusement, d'améliorer les performances de la cellule photovoltaïque, par exemple en augmentant les performances électriques et en diminuant significativement les perturbations au passage de charges. Ceci permet d'obtenir, avantageusement, une couche transparente en face avant.

Les couches en silicium amorphe 2 et 5 sont déposées par toute technique adaptée et par exemple par dépôt en phase vapeur assisté par plasma (PECVD). Préférentiellement, les couches en silicium amorphe 2 et 5 sont déposées à une température inférieure à 220°C, ce qui permet, avantageusement, d'éviter les processus de cristallisation parasites et de protéger la jonction des couches amorphes. La température minimale du dépôt est la température ambiante.

La couche barrière 4 est de nature différente de celles des première 2 et deuxième 3 couches. Par nature différente, on entend que la composition chimique de la couche barrière 4 est différente de la composition chimique de la première couche 2 et de la composition chimique de la deuxième 3 couche.

La couche barrière 4 est formée par un matériau différent de celui formant la première couche 2.

La couche barrière 4 est, préférentiellement, constituée par un matériau différent de celui constituant la couche amorphe 5 destinée à former après dopage par implantation ionique la couche 3. Ceci permet notamment d'empêcher les dopants de pénétrer dans la première couche amorphe 2.

Par exemple, la couche barrière 4 est réalisée dans un matériau présentant une vitesse de diffusion des ions dopants implantés inférieure à la vitesse de diffusion des mêmes ions dopants dans la deuxième couche amorphe 5. De cette manière, lors des budgets thermiques à suivre, cela permet de ralentir suffisamment les dopants pour que ceux-ci ne pénètrent pas dans la première couche amorphe 2.

Dans une variante de réalisation, la couche barrière peut également être réalisée dans un matériau plus difficile à traverser que celui de la couche amorphe 5 de manière à stopper complètement l'implantation ionique. La couche barrière a avantageusement un numéro atomique (Z) supérieur à celui de la couche 5 à doper.

La couche barrière 4 est, selon un mode particulier de réalisation, semi-conductrice. Elle présente une conductivité supérieure à 1.10⁻⁶ S/cm. La couche barrière 4 est par exemple constituée par un matériau semi-conducteur, tel que le carbure de silicium (SiC).

La couche barrière 4 peut aussi être en oxyde de silicium, par exemple en SiOₓ éventuellement dopé, en nitrure de silicium du type SiNₓ éventuellement dopé, en métal, par exemple en Cr, Al, Ni, Ti. La couche barrière 4 peut encore être en oxyde transparent conducteur (également connu sous l'acronyme OTC), tel que l'oxyde d'indium et d'étain (ou ITO pour l'acronyme anglo-saxon« Indium Tin Oxide »).

Les matériaux choisis pour élaborer la couche barrière 4 permettent et/ou facilitent le transport des porteurs de charge nécessaires au fonctionnement de la cellule photovoltaïque, tout en bloquant la diffusion des agents dopants lors de l'implantation ionique.

Préférentiellement, la couche barrière 4 a une épaisseur inférieure à 5nm, pour permettre de conserver la jonction entre le substrat et la couche amorphe dopée. La couche barrière 4 a par ailleurs, de préférence une épaisseur supérieure ou égale à 1nm. Cette gamme d'épaisseur permet avantageusement de passiver correctement la surface tout en évitant les pertes résistives dans les couches.

Selon un mode de réalisation préférentiel, la couche barrière 4 a une épaisseur inférieure à 5nm et elle est semi-conductrice. Ainsi, la couche barrière ne perturbe pas le transport des charges dans la cellule à hétérojonction.

Dans tous les cas, l'épaisseur de la couche barrière 4 doit être inférieure ou égale à 5nm.

Préférentiellement, la couche barrière 4 est aussi transparente. Par transparence, on entend que la couche barrière 4 laisse passer, plus de 90% d'un rayonnement incident reçu par la cellule dans une gamme de longueurs d'onde comprise entre 300nm et 1200nm, lorsque la couche barrière 4 est disposée dans l'empilement de couches minces formés en face avant du substrat. Pour une couche barrière disposée dans un empilement de couches minces disposé en face arrière du substrat 1, la gamme de longueurs d'onde peut être réduite : elle peut être comprise entre 900nm et 1200nm.

La couche barrière 4 étant préférentiellement transparente au rayonnement électromagnétique incident, la cellule photovoltaïque permet de convertir la majeure partie des photons reçus en un signal électrique sans modifier de manière significative le rendement de la cellule photovoltaïque.

Selon un mode de réalisation préférentiel, la couche barrière 4 est formée par dépôt, à une température avantageusement inférieure ou égale à 200°C. Préférentiellement, la température est strictement inférieure à 200°C. Elle est, de plus, avantageusement supérieure ou égale à la température ambiante. La couche barrière 4 est par exemple déposée à une température supérieure à 20°C, et plus particulièrement à une température comprise entre 20°C et 50°C. Elle est formée, par exemple par dépôt chimique en phase vapeur assisté par plasma (PECVD), par dépôt physique en phase vapeur (PVD), par dépôt de couches atomiques (ALD), dépôt chimique en phase vapeur (CVD), évaporation ou implantation ionique.

La présence de la couche barrière 4 entre la première couche 2 et la deuxième 3 couche permet de mieux contrôler le profil de l'implantation en maîtrisant la profondeur de diffusion des ions implantés ou en maîtrisant la profondeur d'implantation maximale, par exemple des ions bore ou phosphore. Il n'y a donc pas d'ions implantés dans la première couche 2, i.e. dans la couche de passivation en silicium amorphe intrinsèque, ce qui permet de réduire considérablement les recombinaisons de surface dans cette dernière couche et permet ainsi d'augmenter le rendement de la cellule photovoltaïque.

De plus, la couche 3 en silicium amorphe est dopée plus facilement sur toute son épaisseur et de manière plus homogène : la couche 3 est suffisamment dopée pour assurer un bon champ électrique dans la cellule photovoltaïque et les performances de la cellule photovoltaïque sont ainsi améliorées.

La profondeur moyenne d'implantation ionique (Rp), lors de l'étape de dopage par implantation ionique réalisée après la formation de la couche barrière, peut se situer au milieu de la couche 5 destinée à être dopée ou encore à l'interface entre cette couche 5 et la couche barrière 4, afin d'obtenir, avantageusement, une couche sur toute son épaisseur. La profondeur moyenne d'implantation ionique correspond à la pénétration des ions dans le matériau (« range » en anglais) et elle dépend de la nature des matériaux rencontrés, de la nature des ions, de leur énergie, etc.

Comme représenté sur la figure 3, la cellule photovoltaïque à hétérojonction ainsi obtenue comprend successivement :
- un substrat 1 en matériau semi-conducteur cristallin, dopé selon un premier type de dopage, et muni d'une première face principale,
- une première couche 2 en matériau semi-conducteur amorphe intrinsèque, sur ladite première face principale du substrat.
- une deuxième couche en matériau semi-conducteur amorphe dopé 3.

La cellule comporte en plus une première couche barrière 4 disposée entre la première couche 2 et la deuxième couche 3, ladite couche barrière 4 étant de nature différente de celles des première et deuxième couches. Préférentiellement, le matériau semi-conducteur est du silicium, i.e. le matériau semi-conducteur cristallin est du silicium cristallin, le matériau semi-conducteur amorphe est du silicium amorphe.

Dans le mode de réalisation décrit à la figure 3, la première face principale du substrat sur lequel est disposé l'empilement successif des couches 2, 4 et 3 correspond à la face avant du substrat. Dans ce cas, la deuxième couche 3 est dopée par implantation ionique selon un dopage de type opposé à celui du substrat 1 (par exemple un dopage P pour un substrat dopé N). Selon une alternative, la première face principale du substrat sur lequel pourrait être disposé l'empilement successif des couches 2, 4 et 3 pourraient aussi bien correspondre à la face arrière du substrat. Dans ce cas, la deuxième couche 3 serait dopée par implantation ionique selon un dopage de même type que celui du substrat 1 (dopage de type N pour un substrat dopé N).

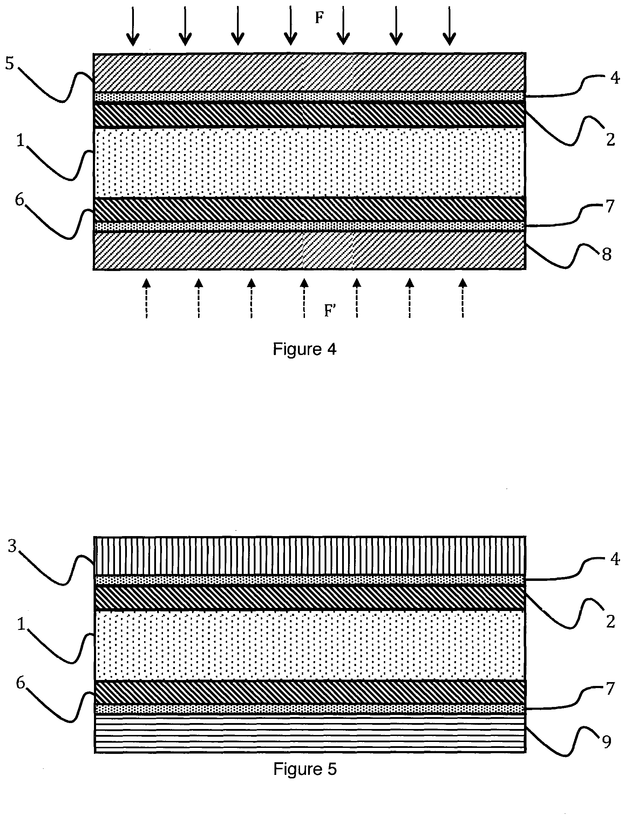

Selon un autre mode particulier de réalisation, et comme représenté sur la figure 4, le procédé de réalisation peut comporter la réalisation de deux empilements successifs de couches minces, respectivement sur ses faces avant et arrière, avec pour chacun la formation d'une couche barrière entre deux couches en silicium amorphe intrinsèque, avant le dopage de la couche supérieure par implantation ionique.

Ainsi, le procédé comporte la première étape suivante : fournir un substrat 1 en matériau semi-conducteur cristallin, dopé d'un premier type de dopage, et muni d'une première face principale, par exemple, la face avant et d'une deuxième face principale, par exemple la face arrière.

Le procédé comporte en plus, pour la face avant du substrat 1, les étapes successives suivantes :
- déposer une première couche 2 en matériau semi-conducteur amorphe intrinsèque, sur la face principale avant du substrat,
- former une deuxième couche 5 en matériau semi-conducteur amorphe sur la première couche 2.

Le procédé comporte, en face avant, le dépôt d'une couche barrière 4 entre la première couche 2 et la deuxième couche 5, ladite couche barrière 4 étant de nature différente de celles des première 2 et deuxième 5 couches.

Le procédé de réalisation comporte, en plus, pour la face arrière du substrat 1, les étapes successives suivantes :
- déposer une troisième couche 6 en matériau semi-conducteur amorphe intrinsèque, sur la face principale arrière du substrat,
- former une quatrième couche 8 en matériau semi-conducteur amorphe sur la troisième couche 6.

Le procédé comporte, en face arrière, le dépôt d'une deuxième couche barrière 7 entre la troisième couche 6 et la quatrième couche 8, ladite couche barrière 7 étant de nature différente de celles des première 6 et deuxième 8 couches.

Le procédé comporte, de plus, le dopage de la deuxième couche 5 et de la quatrième couche 8 par implantation ionique (flèches F et F', respectivement sur la face avant et sur la face arrière su substrat 1).

Préférentiellement, le matériau semi-conducteur est du silicium.

Préférentiellement, pour un substrat en silicium cristallin dopé N, une implantation ionique permettant d'obtenir un dopage selon un type P (flèches F) est réalisée sur la deuxième couche 5 de la face avant. Une couche en silicium amorphe et dopée 3 selon un type P est ainsi obtenue en face avant afin de former une jonction p/n avec le substrat 1. Ceci permet de récupérer le courant de porteurs générés à l'intérieur de la cellule photovoltaïque.

Préférentiellement, en face arrière, une implantation ionique selon un type N (flèches F') est réalisée sur la quatrième couche 8. Une couche 9 en silicium amorphe dopée selon le même type que le substrat, ici de type N, est ainsi obtenue en face arrière afin de former un champ électrique arrière BSF.

Comme représenté sur la figure 5, la cellule photovoltaïque ainsi obtenue comporte l'empilement successif suivant, à partir de la première face principale du substrat 1 en matériau semi-conducteur cristallin, dopé d'un premier type de dopage, la première face principale étant, avantageusement, la face avant :
- une première couche 2 en matériau semi-conducteur amorphe intrinsèque, disposée sur la face principale avant du substrat 1,
- une première couche barrière 4,
- une deuxième couche en matériau semi-conducteur amorphe dopée 3, préférentiellement dopée P si le substrat 1 est dopé de type N.

La deuxième face principale, i. e. la face arrière, du substrat de la cellule photovoltaïque comprend l'empilement suivant à partir du substrat 1 cristallin :
- une troisième couche 6 en matériau semi-conducteur amorphe intrinsèque, disposée sur la face principale arrière du substrat 1,
- une couche barrière 7,
- une quatrième couche en matériau semi-conducteur amorphe dopée 9, préférentiellement dopée N si le substrat 1 est dopé de type N.

La deuxième couche barrière 7 est de nature différente de celles des première 6 et deuxième 9 couches.

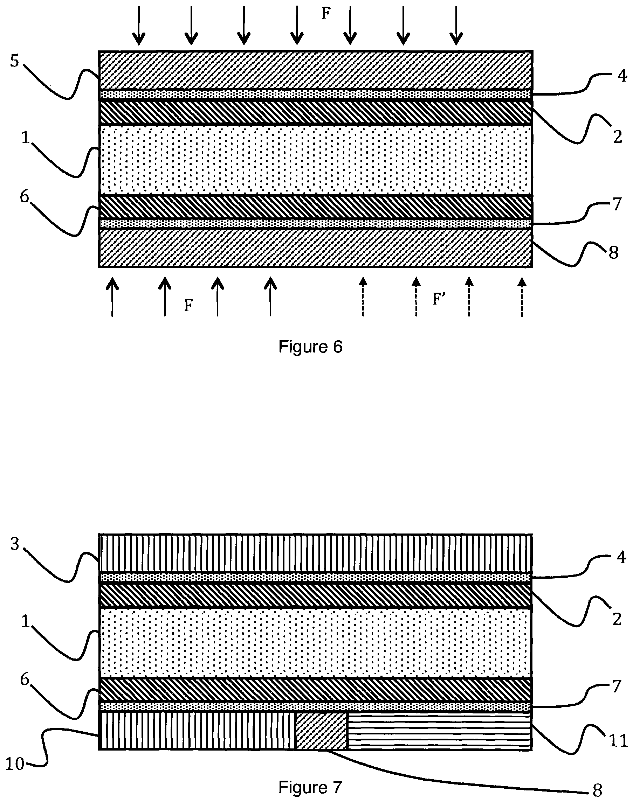

Comme représenté sur la figure 6, selon un autre mode de réalisation particulier, une des couches amorphes 5 et 8 peut être dopée localement selon des types de dopages différents (flèches F et F') : un type de dopage identique à celui du substrat et un type de dopage opposé à celui du substrat. Ceci permet alors de former localement deux types de dopage, de manière à former une première zone de type P adjacente à une deuxième zone de type N. Préférentiellement, la couche dopée selon deux types de dopage différents est la couche amorphe dopée en face arrière, c'est-à-dire la quatrième couche 8.

Par adjacente, on entend que la cellule photovoltaïque ainsi obtenue, comme représentée sur la figure 7, comporte deux zones distinctes, la première zone 10 est dopée P et la deuxième zone 11 est dopée N. Les deux zones 10 et 11 sont préférentiellement situées dans un même plan, elles peuvent être contiguës ou séparées par une zone intermédiaire, par exemple par une zone en silicium amorphe intrinsèque. Il peut s'agir par exemple d'une partie de la quatrième couche 8 qui n'a pas été dopée lors de l'étape de dopage par implantation ionique.

L'utilisation de l'implantation ionique en présence d'une couche barrière permet avantageusement de réaliser facilement ce type de motif de dopage.

Lors des étapes d'élaboration de la cellule photovoltaïque, des recuits peuvent éventuellement être réalisés, par exemple pour modifier le profil de dopage ou stabiliser la structure cristalline des couches déposées et/ou implantées.

Les dopages de type N décrits précédemment sont préférentiellement réalisés par dopage au phosphore et les dopages de type P sont préférentiellement réalisés par dopage au bore.

Les modes de réalisation décrits ci-dessus concernent un substrat cristallin dopé de type N. Selon un autre mode de réalisation, le substrat pourrait être un substrat cristallin dopé de type P. Les dopages des couches amorphes dopées seraient alors inversés, les couches dopées N seraient dopées P et les couches dopées P seraient dopées N.

Ce procédé d'élaboration peut être utilisé non seulement pour des cellules photovoltaïques à hétérojonction (HET), mais aussi à des cellules à hétérojonction à contact face arrière (RCC HET).

Dans les modes de réalisation décrits ci-dessus, la cellule photovoltaïque à hétérojonction est à base de silicium, c'est-à-dire que le substrat 1 et les empilements de couches successives 2, 3, 5, 6, 8 et 9 sont à base de silicium, et de préférence en silicium. Cependant, elles pourraient aussi être à base d'un ou plusieurs autres matériaux semi-conducteurs, tels que le germanium ou un alliage silicium-germanium ou un alliage AsGa. Par ailleurs, elles ne sont pas nécessairement toutes constituées par le même matériau semi-conducteur.

Les différentes possibilités (variantes et modes de réalisation) doivent être comprises comme n'étant pas exclusives les unes des autres et peuvent se combiner entre elles.

## Revendications

1. Procédé de réalisation d'une cellule photovoltaïque à hétérojonction comportant les étapes successives suivantes :
- fournir un substrat (1) en matériau semi-conducteur cristallin, dopé d'un premier type de dopage, et muni d'une première face principale,
- déposer une première couche (2) en matériau semi-conducteur amorphe intrinsèque, sur ladite première face principale du substrat (1),
- former une deuxième couche (5) en matériau semi-conducteur amorphe sur la première couche (2),
**caractérisé en ce qu'**il comporte le dépôt d'une couche barrière (4) entre la première couche (2) et la deuxième couche (5), ladite couche barrière (4) étant de nature différente de celles des première (2) et deuxième (5) couches, l'épaisseur de la couche barrière (4) étant inférieure ou égale à 5 nm,
et **en ce qu'**il comporte le dopage de la deuxième couche (5) par implantation ionique,
la couche barrière (4) étant apte à former une barrière, lors de l'étape de dopage par implantation ionique, à la pénétration des ions dans la première couche (2) et dans le substrat (1) en matériau semi-conducteur cristallin.

2. Procédé selon la revendication 1, **caractérisé en ce que** la couche barrière (4) est semi-conductrice.

3. Procédé selon la revendication 1, **caractérisé en ce que** la couche barrière (4) est en oxyde de silicium, en nitrure de silicium, en métal ou en oxyde transparent conducteur.

4. Procédé selon l'une quelconque des revendications 1 à 3, **caractérisé en ce que** la couche barrière (4) a une épaisseur inférieure à 5nm.

5. Procédé selon l'une quelconque des revendications 1 à 4, **caractérisé en ce que** la couche barrière (4) est transparente.

6. Procédé selon l'une quelconque des revendications 1 à 5, **caractérisé en ce que** la couche barrière (4) est déposée à une température inférieure à 200°C.

7. Procédé selon l'une quelconque des revendications 1 à 6, **caractérisé en ce que** les première (2) et deuxième (5) couches ont chacune une épaisseur inférieure à 15nm.

8. Procédé selon l'une quelconque des revendications 1 à 7, **caractérisé en ce que** l'étape de dopage par implantation ionique de la deuxième couche (5) forme localement deux types de dopage dans ladite couche, de manière à former une première zone de type P adjacente à une deuxième zone de type N.

9. Procédé selon l'une quelconque des revendications 1 à 8, **caractérisé en ce que** l'épaisseur de la couche barrière (4) est supérieure ou égale à 1 nm.

## Patentansprüche

1. Verfahren zur Herstellung einer Photovoltaik-Zelle mit Heteroübergang, das folgende aufeinander folgende Verfahrensschritte umfasst:
- Bereitstellen eines Substrats (1) aus kristallinem Halbleitermaterial, das mit einem ersten Typ von Dotierstoff dotiert ist, und das mit einer ersten Hauptseite versehen ist,
- Auftragen einer ersten Schicht (2) aus eigenleitendem amorphen Halbleitermaterial auf die genannte erste Hauptseite des Substrats (1),
- Bilden einer zweiten Schicht (5) aus amorphem Halbleitermaterial auf der ersten Schicht (2),
**dadurch gekennzeichnet,**
**dass** es das Auftragen einer Sperrschicht (4) zwischen der ersten Schicht (2) und der zweiten Schicht (5) umfasst, wobei die genannte Sperrschicht (4) von anderer Art ist als die erste Schicht (2) und die zweite Schicht (5), wobei die Stärke der Sperrschicht (4) kleiner als oder gleich 5nm ist,
und dadurch, dass es das Dotieren der zweiten Schicht (5) durch Ionenimplantation umfasst,
wobei die Sperrschicht (4) geeignet ist, bei dem Verfahrensschritt des Dotierens durch Ionenimplantation eine Sperre gegen das Eindringen der Ionen in die erste Schicht (2) und in das Substrat (1) aus kristallinem Halbleitermaterial zu bilden.

2. Verfahren nach Anspruch 1,
**dadurch gekennzeichnet,**
**dass** die Sperrschicht (4) halbleitend ist.

3. Verfahren nach Anspruch 1,
**dadurch gekennzeichnet,**
**dass** die Sperrschicht (4) aus Siliziumoxid oder Siliziumnitrid, aus Metall oder aus leitendem transparentem Oxid besteht.

4. Verfahren nach einem der Ansprüche 1 bis 3,
**dadurch gekennzeichnet,**
**dass** die Sperrschicht (4) eine Stärke von weniger als 5nm hat.

5. Verfahren nach einem der Ansprüche 1 bis 4,
**dadurch gekennzeichnet,**
**dass** die Sperrschicht (4) transparent ist.

6. Verfahren nach einem der Ansprüche 1 bis 5,
**dadurch gekennzeichnet,**
**dass** die Sperrschicht (4) bei einer Temperatur von unter 200°C aufgetragen wird.

7. Verfahren nach einem der Ansprüche 1 bis 6,
**dadurch gekennzeichnet,**
**dass** die erste Schicht (2) und die zweite Schicht (5) jeweils ein Stärke von weniger als 15nm haben.

8. Verfahren nach einem der Ansprüche 1 bis 7,
**dadurch gekennzeichnet,**
**dass** der Verfahrensschritt des Dotierens der zweiten Schicht (5) durch Ionenimplantation lokal begrenzt zwei Typen Dotierstoff in dieser Schicht bildet, dergestalt dass ein erster Bereich des Typs P angrenzend an einen zweiten Bereich des Typs N gebildet wird.

9. Verfahren nach einem der Ansprüche 1 bis 8,
**dadurch gekennzeichnet,**
**dass** die Stärke der Sperrschicht (4) größer als oder gleich 1nm ist.

## Claims

1. Method for producing a photovoltaic cell having a heterojunction, comprising the following successive steps:
- providing a substrate (1) made from crystalline semiconductor material, doped with a first doping type, and provided with a first main surface,
- depositing a first layer (2) of intrinsic amorphous semiconductor material on said first main surface of the substrate (1),
- forming a second layer (5) of amorphous semiconductor material on the first layer (2),
**characterized in that** it comprises deposition of a barrier layer (4) between the first layer (2) and the second layer (5), said barrier layer (4) being of a different nature from those of the first layer (2) and second layer (5), the thickness of the barrier layer (4) being less than or equal to 5nm,
and **in that** it comprises doping of the second layer (5) by ion implantation,
the barrier layer (4) being able to form a barrier, during the ion implantation stage, preventing penetration of the ions into the first layer (2) and into the crystalline semiconductor material substrate (1).

2. Method according to claim 1, **characterized in that** the barrier layer (4) is semiconducting.

3. Method according to claim 1, **characterized in that** the barrier layer (4) is made from silicon oxide, silicon nitride, metal or a transparent conducting oxide.

4. Method according to any one of claims 1 to 3, **characterized in that** the barrier layer (4) has a thickness of less than 5nm.

5. Method according to any one of claims 1 to 4, **characterized in that** the barrier layer (4) is transparent.

6. Method according to any one of claims 1 to 5, **characterized in that** the barrier layer (4) is deposited at a temperature of less than 200°C.

7. Method according to any one of claims 1 to 6, **characterized in that** the first layer (2) and second layer (5) each have a thickness of less than 15nm.

8. Method according to any one of claims 1 to 7, **characterized in that** the ion implantation doping step of the second layer (5) locally forms two types of doping in said layer so as to form a first P-doped area adjacent to a second N-doped area.

9. Method according to any one of claims 1 to 8, **characterized in that** the thickness of the barrier layer (4) is greater than or equal to 1nm.
